# EUROPÄISCHE PATENTSCHRIFT

(11) **EP 1 795 779 B1**
(45) Veröffentlichungstag und Bekanntmachung des Hinweises auf die Patenterteilung: **06.07.2011**
(21) Anmeldenummer: 06121842.6
(22) Anmeldetag: 05.10.2006
(51) Int. Cl.: H05K 13/04, F16H 13/02, F16H 55/34

(54) **Bestückkopf zum Bestücken von Substraten mit elektrischen Bauteilen**
Means for loading substrates with electric components
Bras manipulateur pour insérer des composants eléctriques

(30) Priorität: 06.12.2005 DE 102005058283
(43) Veröffentlichungstag der Anmeldung: 13.06.2007
(73) Patentinhaber: ASM Assembly Systems GmbH & Co. KG, 81379 München (DE)
(72) Erfinder: Andersch, Walter, 85551 Kirchheim (DE); Burger, Stefan, 81379 München (DE)
(74) Vertreter: Patentanwälte Bals & Vogel

(56) Entgegenhaltungen:
- DE-A1- 1 435 667
- DE-A1- 10 305 370
- US-A- 3 965 762
- US-A- 6 145 901
- US-A1- 2002 032 960
- US-A1- 2002 046 461
- US-A1- 2002 124 393

## Beschreibung

Die Erfindung betrifft einen Bestückkopf zum Bestücken von Substraten mit elektrischen Bauteilen, welcher eine Getriebevorrichtung aufweist, gemäß dem Oberbegriff des Anspruchs 1. Ein entsprechender Bestückkopf ist aus dem Dokument US 2002/0124393A1 bekannt. Aus der Offenlegungsschrift EP-0939584 ist ein Bestückkopf zum Bestücken von Substraten mit elektrischen Bauteilen bekannt geworden, welcher über eine Greifereinheit zum Halten der Bauteile verfügt. Die Greifereinheit ist am Ende einer drehbar gelagerten Welle befestigt. Der Bestückkopf weist ferner einen Drehantrieb auf, der über ein Zahnradgetriebe mit der Welle gekoppelt ist, und so die an der Greifereinheit befindlichen Bauteile in eine gewünschte Winkellage dreht. Aufgrund des Spiels im Zahnradgetriebe kann es zu Ungenauigkeiten beim Einstellen der Winkellage kommen.

In der Patentschrift EP-1169809 ist ein Bestückkopf offenbart, bei dem die auf einer drehbaren Welle befestigten Greifereinheiten durch Ankoppeln eines externen Reibrades an die Welle gedreht. Zum Aufbringen der nötigen Reibkraft werden die Reibräder seitlich an die Wellen gepresst, wodurch die Wellenlager einseitig belastet werden. Dadurch kann die Bestückgenauigkeit des Bestückkopfes negativ beeinträchtigt werden.

Es ist daher die Aufgabe der vorliegenden Erfindung einen Bestückkopf mit einer Getriebevorrichtung zu liefern, bei welchem die Übertragung der Drehbewegung mit höherer Genauigkeit durchführbar ist.

Diese Aufgabe wird durch den Bestückkopf gemäß dem unabhängigen Anspruch gelöst.

Vorteilhafte Ausgestaltungen der Erfindung sind Gegenstand der Unteransprüche.

Ein erfindungsgemäßer Bestückkopf gemäß Anspruch 1 zum Bestücken von Substraten mit elektrischen Bauteilen weist zumindest eine Getriebevorrichtung und zumindest eine Greifereinheit zum Halten der Bauteile auf. Die Greifereinheit ist mit der Welle derart gekoppelt, dass sie sich zusammen mit der Welle dreht. Die Getriebevorrichtung weist eine drehbar gelagerte Welle mit einer ersten Abrollfläche und einen beweglich gelagerten Antriebskörper mit einer zweiten Abrollfläche auf. Die Welle und der Antriebskörper sind derart ausgebildet und angeordnet, dass die erste Abrollfläche unter Einwirkung einer Magnetkraft derart in Wechselwirkung mit der zweiten Abrollfläche steht, dass sich die Welle bei Bewegung des Antriebskörpers unter Abrollen der ersten Abrollfläche an der zweiten Abrollfläche dreht. Die für eine reibschlüssige Verbindung zwischen dem Antriebskörper und der Welle notwendige Normalkraft wird durch Wirken einer magnetischen Anziehungskraft zwischen dem Antriebskörper und der Welle erzeugt. Eine seitliche Anpresskraft des Antriebskörpers gegen die Welle, wie es beispielsweise bei den aus dem Stand der Technik bekannten Reibrädern erforderlich ist, ist dadurch nicht nötig. Dadurch wirken auf die Welle keine seitlichen Querkräfte, welche die Genauigkeit der Drehbewegung negativ beeinträchtigen würden. Aufgrund der festen reibschlüssigen Verbindung zwischen Antriebskörper und der Welle ist, im Unterschied zu den aus dem Stand der Technik bekannten Zahnradgetrieben, ein vollständig spielfreies Drehen der Welle möglich. Insbesondere kann dadurch die Drehrichtung der Welle spielfrei umgekehrt werden, was beispielsweise bei einem Zahnradgetriebe nicht möglich ist. Da bei der Umkehr der Drehrichtung der Welle kein Spiel zwischen Antriebskörper und Welle auftritt, wird die Genauigkeit der Winkelpositionierung der Welle spürbar verbessert.

Gerade in der Bestücktechnik sind die Genauigkeitsanforderungen an den Bestückkopf besonders groß. Durch die Verwendung der Getriebevorrichtung zum Drehen der Greifereinheit wird die Drehbewegung spielfrei und ohne seitliche Belastung der Welle übertragen. Dadurch ergeben sich für die Einstellung einer gewünschten Winkellage der Bauteile an den Greifereinheiten erhebliche Genauigkeitsvorteile. Ansonsten gelten analog die bezüglich der Ansprüche 1 bis 3 genannten Vorteile.

Gemäß einer-Ausgestaltung des Bestückkopfs nach Anspruch 2 weist der Antriebskörper ferromagnetisches Material auf. So kann der Antriebskörper beispielsweise aus Stahl gefertigt sein. Die Welle weist einen stabförmigen Grundkörper auf, welcher sich in einer Längsrichtung erstreckt und auf welchen zwei in der Längsrichtung beabstandete ferromagnetische Abrollelemente und ein zwischen den Abrollelementen vorgesehener Permanentmagnet angeordnet sind. An den Umfangsflächen der Abrollelemente sind jeweils die ersten Abrollflächen ausgebildet. Bei dieser Ausgestaltung wird die die Welle und den Antriebskörper verbindende Normalkraft durch den an der Welle angeordneten Permanentmagneten erzeugt. Dadurch, dass der Permanentmagnet zwischen zwei ferromagnetischen Abrollelementen angeordnet ist, wird das Magnetfeld bzw. der magnetische Fluss deutlich verstärkt. Sowohl der Antriebskörper als auch die Abrollelemente können beispielsweise aus Stahl gefertigt sein. Dadurch ergibt sich gegenüber herkömmlich verwendeten Elastomer-Reibrädern ein geringerer Verschleiß sowie aufgrund der höheren Steifigkeit von Stahl eine höhere Genauigkeit bei der Übertragung der Drehbewegung. Gegenüber von Zahnradgetrieben sind die geringeren Fertigungskosten zu erwähnen.

In einer Ausgestaltung gemäß Anspruch 3 ist zumindest eine der ersten Abrollfläche und zweiten Abrollfläche geschliffen ausgeführt. Dadurch ist eine sehr präzise geometrische Abstimmung der ersten und zweiten Abrollflächen 11, 14 aufeinander möglich und die Querbelastung der Welle kann minimiert oder gar vollständig eliminiert werden.

Gemäß einer Ausgestaltung des Bestückkopfs nach Anspruch 4 umfasst jede Getriebevorrichtung jeweils einen individuellen Antriebskörper, wobei jeder Antriebskörper mit einem individuellen Motor zum Bewegen des Antriebskörpers gekoppelt ist. Bei dieser Ausgestaltung können bei einem Bestückkopf mit mehreren, mit den Wellen der Getriebevorrichtungen gekoppelten Greifereinheiten, sämtliche Greifereinheiten individuell und unabhängig voneinander gedreht werden, um die daran gehaltenen Bauteile in eine gewünschte Winkellage zu bringen. Dadurch können sämtliche Bauteile schon vor Aufnahme des Bestückvorganges gedreht werden, was Zeitvorteile für den Bestückvorgang bringt. Auch ein gleichzeitiges Bestücken mit mehreren Bauteilen ist dadurch möglich.

Gemäß einer weiteren Ausgestaltung des Bestückkopfs nach Anspruch 5 weist jeder Antriebskörper eine zylindrische Form auf. Die zweite Abrollfläche ist dabei an der Mantelfläche des Antriebskörpers ausgebildet. Die so gestalteten Antriebskörper gewährleisten eine sehr kompakte und Platz sparende Bauweise. Ferner kann durch entsprechende Dimensionierung der Durchmesser des Antriebskörpers und der Abrollelemente bzw. der Welle ein gewünschtes Übersetzungsverhältnis eingestellt werden. Ferner können die Antriebskörper unmittelbar und ohne Getriebe durch einen kostengünstigen Elektromotor angetrieben werden.

In einer Ausgestaltung des Bestückkopfs nach Anspruch 6 umfasst dieser zumindest zwei Greifereinheiten, wobei der Antriebskörper der Getriebevorrichtungen als gemeinsamer Antriebskörper ausgebildet ist. Der gemeinsame Antriebskörper ist ferner mit einem Motor zum Bewegen des gemeinsamen Antriebskörpers gekoppelt. Bei dieser Ausgestaltung des Bestückkopfes werden die Wellen mittels nur eines gemeinsamen Antriebskörpers gedreht. Zwar ist die individuelle Drehung der Wellen nicht mehr möglich, jedoch ergibt sich durch die Anwesenheit von nur einem Motor eine einfachere Steuerung der Drehvorgänge. Ferner kann der Bestückkopf noch kompakter, kostengünstiger und leichter gebaut werden.

Der Bestückkopf kann gemäß Anspruch 7 auch dahingehend ausgestaltet werden, dass die Wellen der Getriebevorrichtungen an zwei gegenüberliegenden Randbereichen eines Gehäuses des Bestückkopfes angeordnet sind. Der gemeinsame Antriebskörper weist dabei an gegenüberliegenden Wandabschnitten jeweils zweite Abrollflächen auf, und ist derart zwischen den Wellen angeordnete dass sich die Wellen bei Bewegung des Antriebskörpers drehen. Durch die Anordnung der Greifereinheiten an zwei gegenüberliegenden Randbereichen des Gehäuses und die mittige Anordnung des gemeinsamen Antriebskörpers kann der Bauraum des Bestückkopfes optimal ausgenutzt werde. Dies verleiht dem Bestückkopf eine sehr kompakte, leichte und preisgünstige Bauweise.

Da die Wellen aufgrund des Einsatzes der Getriebevorrichtung keine seitliche Anpresskraft erfahren, ist, gemäß Anspruch 8, der Einsatz von Gleitlagern zur Lagerung der Wellen im Bestückkopf möglich. Gleitlager zeichnen sich gegenüber Kugellagern durch geringere Baugröße, geringere Kosten, verringerte Masse und eine höhere Genauigkeit aus.

Im Folgenden wird ein Ausführungsbeispiel der Erfindung unter Bezug auf die beigefügten Figuren näher erläutert. In den Figuren sind:
Figur 1a eine Frontalansicht, teilweise im Querschnitt, eines ersten Ausführungsbeispiels des erfindungsgemäßen Bestückkopfes mit Getriebevorrichtung;
Figur 1b eine Seitenansicht, teilweise im Querschnitt, des Bestückkopfs der Figur 1a;
Figur 1c eine Draufsicht, teilweise im Querschnitt, des Bestückkopfs der Figur 1a;
Figur 2 eine vergrößerte Teilansicht der Getriebevorrichtung des Bestückkopfs aus Figur 1a;

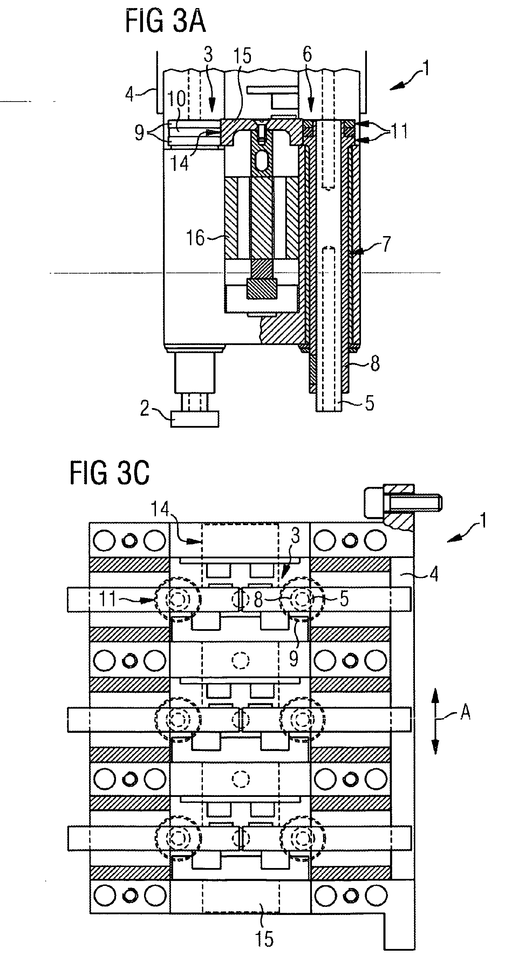

Figur 3a eine Frontalansicht, teilweise im Querschnitt, eines zweiten Ausführungsbeispiels des erfindungsgemäßen Bestückkopfes mit Getriebevorrichtung;

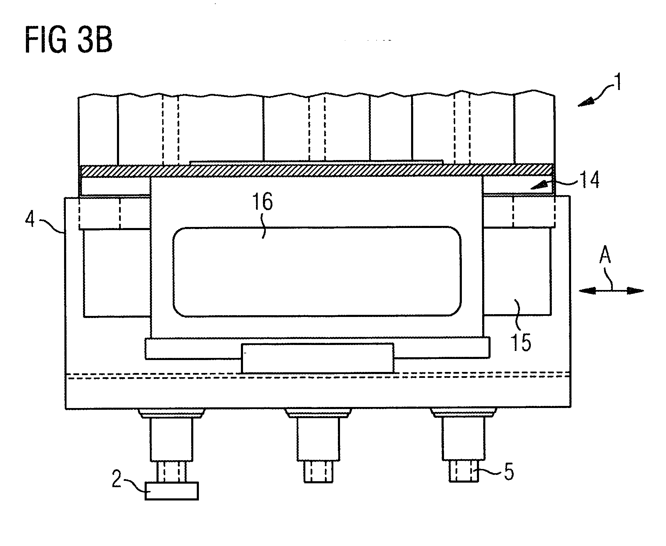

Figur 3b eine Seitenansicht, teilweise im Querschnitt, des Bestückkopfs der Figur 3a;
Figur 3c eine Draufsicht, teilweise im Querschnitt, des Bestückkopfs der Figur 3a;
Figur 4 eine vergrößerte Teilansicht der Getriebevorrichtung des Bestückkopfs aus Figur 3a;

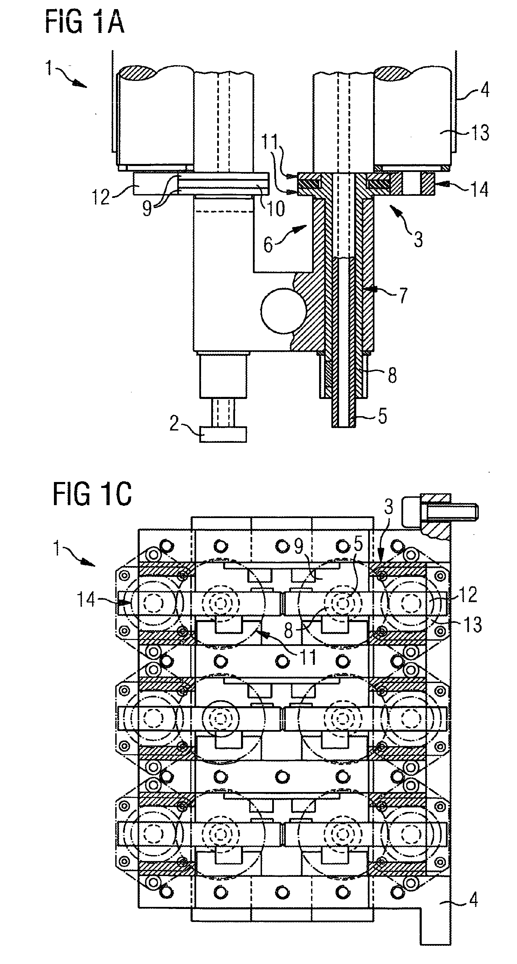

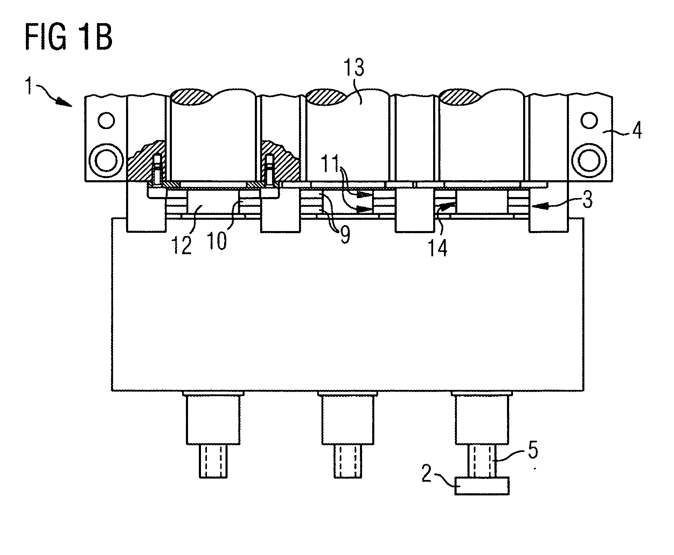

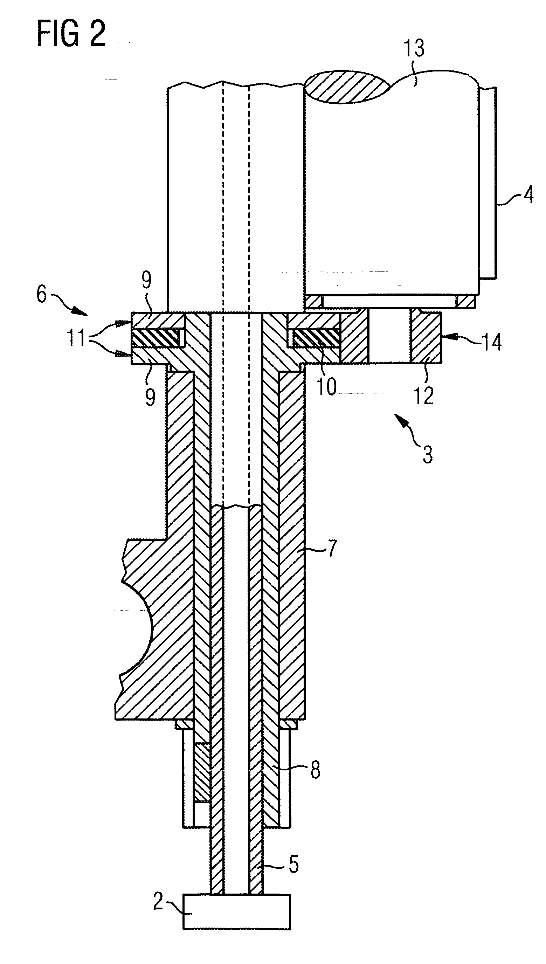

In den Figuren 1a bis 1c und Figur 2 ist ein erstes Ausführungsbeispiel eines Bestückkopfes 1 zum Bestücken von Substraten mit elektrischen Bauteilen 2 mit einer Getriebevorrichtung 3 dargestellt. Dabei ist Figur 2 eine vergrößerte Detailansicht der Getriebevorrichtung 3 aus Figur 1a. In einem Gehäuse 4 des Bestückkopfes 1 sind insgesamt 6 Getriebevorrichtungen 3 zum Drehantrieb von sechs Greifereinheiten 5 zum Halten der Bauteile 2 angeordnet. Wie aus Figur 1c hervorgeht, sind an gegenüberliegenden Seiten des Gehäuses 4 jeweils drei der Getriebevorrichtungen 3 zusammen mit den Greifereinheiten 5 vorgesehen.

Aus den Figuren 1a und 2 geht hervor, dass jede der Getriebevorrichtungen 3 eine Welle 6, welche in einem im Gehäuse 4 ausgebildeten Gleitlager 7 drehbar gelagert ist, umfasst. Die Welle 6 weist dabei einen stabförmigen Grundkörper 8 auf, welcher sich in einer Längsrichtung erstreckt. Im Ausführungsbeispiel ist der Grundkörper 8 als Hohlwelle ausgebildet. Auf dem Grundkörper 8 sind zwei in der Längsrichtung bzw. in Richtung der Drehachse beabstandete ferromagnetische Abrollelemente 9 und ein zwischen den Abrollelementen 9 vorgesehener Permanentmagnet 10 angeordnet bzw. ausgebildet. Bei dem in den Figuren 1a und 2 dargestellten Ausführungsbeispiel ist das untere der beiden Abrollelemente 9 im Grundkörper 8 der Welle 6 integriert. Das obere der beiden Abrollelemente 9 und der Permanentmagnet 10 haben die Form einer ringförmigen Scheibe bzw. einer Hülse, und sind auf den Grundkörper 8 der Welle 6 aufgesteckt. Die Welle 6 verfügt über eine erste Abrollfläche 11, welche im ersten Ausführungsbeispiel an den Umfangsflächen der Abrollelemente 9 ausgebildet ist. Beide Abrollelemente 9 bestehen vorzugsweise aus ferromagnetischem, gehärtetem Material. Diese Anordnung gewährleistet, dass das von dem Permanentmagnet 10 ausgehende Magnetfeld durch die ihn seitlich umfassenden Abrollelemente 9 verstärkt wird und gleichzeitig das relativ spröde Material des Permanentmagneten 10 durch die gehärteten Abrollelemente 9 sicher vor Beschädigung geschützt werden.

Jede der Getriebevorrichtungen 3 weist ferner einen individuellen Antriebskörper 12 auf, wobei jeder individuelle Antriebskörper 12 mit einem individuellen Motor 13 zum eigenen Drehantrieb gekoppelt ist. Im ersten Ausführungsbeispiel hat jeder individuelle Antriebskörper 12 eine zylindrische Form, wobei an der Mantelfläche des individuellen Antriebskörpers 12 eine zweite Abrollfläche 14 ausgebildet ist. Jede Welle 6 und jeder der zugeordneten individuellen Antriebskörper 12 sind dabei derart im Gehäuse 4 des Bestückkopfes 1 angeordnet, dass die erste Abrollfläche 11 der Welle 6 unter Einwirkung der von dem Permanentmagneten 10 ausgehenden Magnetkraft derart in Wechselwirkung mit der zweiten Abrollfläche 14 des individuelle Antriebskörpers 12 steht, dass sich die Welle 6 bei Drehung des individuellen Antriebskörpers 12 unter Abrollen der ersten Abrollfläche 11 an der zweiten Abrollfläche 14 dreht. Die erste Abrollfläche 11 steht in Reibkontakt mit der zweiten Abrollfläche 14, wobei die zur Erzeugung der Reibkraft nötige Normalkraft durch die magnetische Anziehung zwischen den Permanentmagneten 10 bzw. den das Magnetfeld verstärkenden Abrollelementen 9 und dem individuellen Antriebskörper 12 erzeugt wird. Aus diesem Grund sind die individuellen Antriebskörper 12 der Getriebevorrichtungen 3 aus ferromagnetischem Material gefertigt. Ferner ist zumindest die erste Abrollfläche 11 bzw. die Umfangsflächen der Abrollelemente 9 geschliffen, was eine sehr präzise Abstimmung der ersten und zweite Abrollflächen 11, 14 aufeinander ermöglicht, sodass die Querbelastung der Welle minimiert oder gar vollständig eliminiert werden kann. Durch entsprechende Dimensionierung der Durchmesser der Abrollelemente 9 im Verhältnis zu dem Durchmesser des individuellen Antriebskörpers 12 können stufenlos verschiedene Übersetzungsverhältnisse realisiert werden. Bei den individuellen Motoren 13 zum Antrieb der individuellen Antriebskörper 12 kann es sich um Schrittmotoren oder auch um Servomotoren handeln.

Im ersten Ausführungsbeispiel sind die hohlwellen- bzw. rohrförmig ausgebildeten Greifereinheiten 5 in den Innenraum des hohlwellenförmig ausgebildeten Grundkörpers 8 der Welle 6 eingeschoben und dort drehfest verankert, sodass sich die Greifereinheiten 5 zusammen mit der Welle 6 drehen. Die Innenkanäle der Greifereinheiten 5 können mit einer nicht dargestellten Vakuum- oder Druckluftversorgung verbunden sein, so dass Bauteile 2 an der Spitze der Greifereinheit 5 angesaugt und abgeblasen werden können.

Wie oben schon erwähnt wurde, verfügt jede Getriebevorrichtung 3 im ersten Ausführungsbeispiel über einen individuellen Antriebskörper 12, welcher jeweils mit einem individuellen Motor 13 gekoppelt ist. Dadurch ist es möglich, die an den Greifereinheiten 5 gehaltenen Bauteile 2 unabhängig voneinander in eine gewünschte Winkellage zu drehen. Dadurch können auch mehrere Bauteile 2 auf ein (nicht dargestelltes) Substrat abgesetzt werden. Selbst bei nicht gleichzeitigem Bestücken können sämtliche Bauteile 2 an den Greifereinheiten 5 schon rechtzeitig vor dem Bestückvorgang in die gewünschte Winkellage gedreht werden. Dadurch ergeben sich für den Bestückvorgang Zeitvorteile.

Bei den Getriebevorrichtungen 3 sind, wie oben erwähnt, die Wellen 6 durch die individuellen Antriebskörper 12 seitlich nicht belastet. Dadurch wird der Einsatz hochpräziser, kostengünstiger und Platz sparender Gleitlager 7 möglich. Dadurch kann der Bauraum innerhalb des Gehäuses 4 verkleinert werden, was den gesamten Bestückkopf 1 kompakter macht. Auch ergeben sich Gewichtsvorteile. Durch die zwischen den individuellen Antriebskörpern 12 und den zugeordneten Abrollelementen 9 herrschende Magnetkraft kann ein relativ starker Reibschluss erreicht und somit ein relativ hohes Drehmoment übertragen werden. Im Falle einer Ausgestaltung der individuellen Antriebskörper 12 und der Abrollelemente 9 aus Stahl ergibt sich durch die hohe Steifigkeit dieses Werkstoffes eine sehr hohe Steuergenauigkeit der Drehbewegungsübertragung. Durch den Reibschluss zwischen den individuellen Antriebskörpern 12 und den Abrollelementen 9 liegt auch eine spielfreie Übertragung der Drehbewegung vor. Auch die Umkehr der Drehrichtung kann spielfrei durchgeführt werden. Die in dem Bestückkopf 1 verwendeten Getriebevorrichtungen 3 zeichnen sich ferner durch geringe Fertigungskosten und einen äußerst geringen Verschleiß und somit durch eine hohe Dauerhaltbarkeit auf.

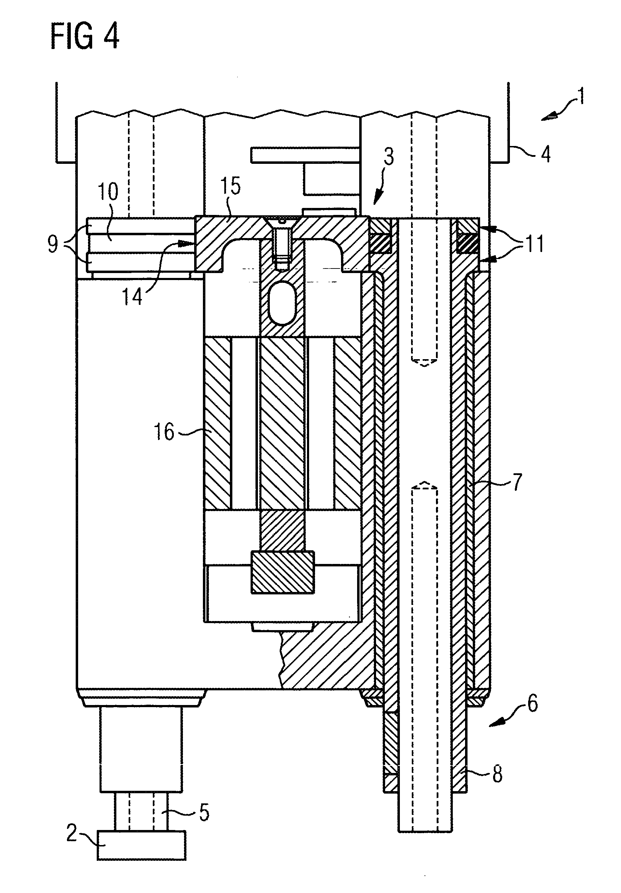

In den Figuren 2a bis 2c und Figur 4 ist ein zweites Ausführungsbeispiel des erfindungsgemäßen Bestückkopfes 1 dargestellt. In Figur 4 ist eine Detailansicht der Getriebevorrichtung 3 aus Figur 2a vergrößert dargestellt. In der folgenden Beschreibung werden nur die Unterschiede zum ersten Ausführungsbeispiel gemäß den Figuren 1a bis 2 herausgestellt. Ansonsten sind gleiche Bauteile gleich ausgeführt.

Im zweiten Ausführungsbeispiel sind die Wellen 6 und die Greifereinheiten 5 identisch mit den denen des ersten Ausführungsbeispiels aufgebaut. Im Unterschied zum ersten Ausführungsbeispiel des Bestückkopfes 1 gemäß den Figuren 1a bis 2 weisen die Getriebevorrichtungen 3 anstatt der individuellen Antriebskörper 12 einen gemeinsamen Antriebskörper 15 auf. Die Wellen 6 der Getriebevorrichtungen 3 sind dabei an zwei gegenüberliegenden Randbereichen des Gehäuses 4 angeordnet.

Der lang gestreckte, plattenförmige, im Querschnitt T-förmig ausgebildete gemeinsame Antriebskörper 15 ist in einem Mittelbereich des Gehäuses 4 zwischen den Wellen 6 angeordnet. An gegenüberliegenden Wandabschnitten des gemeinsamen Antriebskörpers 15 sind jeweils zweite Abrollflächen 14 derart ausgebildet, dass sie den ersten Abrollflächen 11 der Abrollelemente 9 der Wellen 6 zugewandt und mit ihnen in Reibkontakt stehen. Zumindest der Abschnitt des gemeinsamen Antriebskörpers 15, an den die zweiten Abrollflächen 14 ausgebildet sind, ist vorzugsweise aus einem ferromagnetischen Material gefertigt. Die zweiten Abrollflächen 14 können geschliffen sein, um eine optimale Abstimmung an die erste Abrollfläche 11 zu gewährleisten. Somit kann, wie schon bezüglich des ersten Ausführungsbeispiels erwähnt, aufgrund der zwischen dem gemeinsamen Antriebskörper 15 und dem Permanentmagneten 10 herrschenden magnetischen Anziehungskraft ein reibschlüssiger Kontakt zwischen den ersten und zweiten Abrollflächen 11, 14 erreicht werden.

Der gemeinsame Antriebskörper 15 ist in einer Bewegungsrichtung (Pfeil A) linear verschieblich im Gehäuse 4 gelagert. Ferner ist er mit einem Motor 16 gekoppelt, mittels welchem der gemeinsame Antriebskörper 15 in der Bewegungsrichtung verschoben werden kann. Bei dem Motor 16 kann es sich beispielsweise um einen Linearmotor oder auch einem Elektromotor, welcher über Riemen oder Zahnstangengetriebe mit dem gemeinsamen Antriebskörper 15 gekoppelt sind, handeln. Durch den reibschlüssigen Kontakt des gemeinsamen Antriebskörpers 15 mit den Abrollelementen 9 der Wellen 6, bewirkt eine Verschiebung des gemeinsamen Antriebskörpers 15 eine Drehung der Wellen 6. Auf diese Weise können an den Greifereinheiten 5 gehaltene Bauteile 2 in gewünschte Winkellagen gedreht werden.

Das zweite Ausführungsbeispiel des Bestückkopfes 1 weist sich durch seine besonders kostengünstige Bauweise aus. Im Unterschied zum ersten Ausführungsbeispiel können die Wellen 6 nur gemeinsam gedreht werden, weshalb die an den Greifereinheiten 5 gehaltenen Bauteile 2 immer nur vor dem Bestückvorgang in die gewünschte Winkellage gedreht werden können. Eine individuelle unabhängige Drehung der Wellen 6 ist hier nicht möglich. Jedoch ergibt sich durch den gemeinsamen Antriebskörper 15 ein deutlich geringerer Steueraufwand. Da nur ein Motor 16 und nur ein gemeinsamer Antriebskörper vorgesehen sind, ergeben sich aus kostenmäßige Vorteile. Durch die mittige Anordnung des gemeinsamen Antriebskörpers 15 und die auf beiden Seiten des gemeinsamen Antriebskörpers 15 vorgesehenen Wellen 6 bzw. Greifereinheiten 5 kann der Bauraum innerhalb des Gehäuses 4 des Bestückkopfes 1 optimal genutzt werden, was den Bestückkopf 1 noch kompakter und leichter macht. Ansonsten gelten die bezüglich des ersten Ausführungsbeispiels genannten Vorteile des Bestückkopfes 1 bzw. der Getriebevorrichtung 3 analog.

Auch wenn in den oben beschriebenen Ausführungsbeispielen der Permanentmagnet 10 auf den Wellen 6 der Getriebevorrichtung 3 angeordnet ist, so muss das nicht notwendigerweise so sein. Es sind auch Ausgestaltungen denkbar, bei welchen der Permanentmagnet 10 auf den Antriebskörpern (12, 15) angeordnet ist. Die zwei ferromagnetischen Abrollelemente 9 dienen der Verstärkung des von den Permanentmagneten 10 ausgehenden Magnetfeldes und sind deshalb als vorteilhafte Ausgestaltung anzusehen. Es sind jedoch auch Ausgestaltungen denkbar, bei denen auf die Abrollelemente 9 verzichtet wird und die erste Abrollfläche 11 unmittelbar auf den Permanentmagneten 10 ausgebildet ist.

### Bezugszeichenliste

- 1: Bestückkopf
- 2: Elektrisches Bauteil
- 3: Getriebevorrichtung
- 4: Gehäuse
- 5: Greifereinheit
- 6: Welle
- 7: Gleitlager
- 8: Grundkörper
- 9: Abrollelemente
- 10: Permanentmagnet
- 11: Erste Abrollfläche
- 12: Individueller Antriebskörper
- 13: Individueller Motor
- 14: Zweite Abrollfläche
- 15: Gemeinsamer Antriebskörper
- 16: Motor

## Patentansprüche

1. Bestückkopf (1) zum Bestücken von Substraten mit elektrischen Bauteilen (2)
mit zumindest einer Getriebevorrichtung (3) und
mit zumindest einer Greifereinheit (5) zum Halten der Bauteile (2), welche mit der Welle (6) derart gekoppelt ist, dass sie sich zusammen mit der Welle (6) dreht **dadurch gekennzeichnet, daß** die Getriebevorrichtung (3)
- eine drehbar gelagerten Welle (6) mit einer ersten Abrollfläche (11) und
- einen beweglich gelagerten Antriebskörper (12, 15) mit einer zweiten Abrollfläche (14) aufweist,
wobei die Welle (6) und der Antriebskörper (12, 15) derart ausgebildet sind, dass die erste Abrollfläche (11) unter Einwirkung einer Magnetkraft derart in Wechselwirkung mit der zweiten Abrollfläche (14) steht, dass sich die Welle (6) bei Bewegung des Antriebkörpers (12, 15) unter Abrollen der ersten Abrollfläche (11) an der zweiten Abrollfläche (14) dreht.

2. Bestückkopf (1) nach Anspruch 1, wobei
- der Antriebskörper (12, 15) ferromagnetisches Material aufweist,
- die Welle (6) einen stabförmigen Grundkörper (8) aufweist, welcher sich in einer Längsrichtung erstreckt und an welchem zwei in der Längsrichtung beabstandete ferromagnetische Abrollelemente (9) und ein zwischen den Abrollelementen (9) vorgesehener Permanentmagnet (10) angeordnet sind, wobei die erste Abrollfläche (11) an den Umfangsflächen der Abrollelemente (9) ausgebildet ist.

3. Bestückkopf (1) nach einem der Ansprüche 1 bis 2, wobei zumindest eine der ersten Abrollfläche (11) und der zweiten Abrollfläche (14) geschliffen ausgebildet sind.

4. Bestückkopf (1) nach einem der Ansprüche 1 bis 3, wobei jede Getriebevorrichtung (3) jeweils einen individuellen Antriebskörper (12) aufweist, und jeder individuelle Antriebskörper (12) mit einem individuellen Motor (13) zum Bewegen des individuellen Antriebskörpers (12) gekoppelt ist.

5. Bestückkopf (1) nach Anspruch 4, wobei jeder individuelle Antriebskörper (12) eine zylindrische Form aufweist und an der Mantelfläche des individuellen Antriebskörpers (12) die zweite Abrollfläche (14) ausgebildet ist.

6. Bestückkopf (1) nach einem der Ansprüche 1 bis 3, mit mindestens zwei Greifereinheiten (5), wobei der Antriebskörper der Getriebevorrichtungen (3) als gemeinsamer Antriebskörper (15) ausgebildet ist, welcher mit einem Motor (16) zum Bewegen des gemeinsamen Antriebskörpers (15) gekoppelt ist.

7. Bestückkopf (1) nach Anspruch 6, mit einem Gehäuse (4), wobei
- die Wellen (6) der Getriebevorrichtungen (3) an zwei gegenüberliegenden Randbereichen des Gehäuses (4) angeordnet sind,
- der gemeinsame Antriebskörper (15) an gegenüberliegenden Wandabschnitten jeweils zweite Abrollflächen (14) aufweist und derart zwischen den Wellen (6) angeordnet ist, dass sich die Wellen (6) bei Bewegung des gemeinsamen Antriebskörpers (15) drehen.

8. Bestückkopf (1) nach einem der Ansprüche 1 bis 7, wobei die Wellen (6) der Getriebevorrichtungen (3) in Gleitlagern (7) gelagert sind.

## Claims

1. A pick-and-place head (1) for providing substrates with electrical components (2)
with at least one gear transmission device (3) and with at least one gripper unit (5) for holding the components (2), which is coupled with the shaft (6) in such a way that it rotates together with the shaft (6), **characterised in that** the gear transmission device (3) comprises
- a rotatably mounted shaft (6) with a first roll-off face (11) and
- a movably mounted drive body (12, 15) with a second roll-off face (14),
wherein the shaft (6) and the drive body (12, 15) are constituted in such a way that the first roll-off face (11) interacts with the second roll-off face (14) under the effect of a magnetic force, in such a way that the shaft (6) rotates upon movement of the drive body (12, 15), the first roll-off face (11) rolling off on the second roll-off face (14).

2. The pick-and-place head (1) according to claim 1, wherein
- the drive body (12, 15) comprises ferromagnetic material,
- the shaft (6) comprises a rod-shaped base body (8), which extends in a longitudinal direction and on which there are disposed two ferromagnetic roll-off elements (9) spaced apart in the longitudinal direction and a permanent magnet (10) provided between the roll-off elements (9), wherein the first roll-off face (11) is formed on the peripheral faces of the roll-off elements (9).

3. The pick-and-place head (1) according to any one of claims 1 to 2, wherein at least one of the first roll-off face (11) and the second roll-off face (14) are constituted ground.

4. The pick-and-place head (1) according to any one of claims 1 to 3, wherein each gear transmission device (3) in each case comprises an individual drive body (12), and each individual drive body (12) is coupled with an individual motor (13) for the movement of the individual drive body (12).

5. The pick-and-place head (1) according to claim 4, wherein each individual drive body (12) has a cylindrical shape and the second roll-off face (14) is formed on the lateral surface of the individual drive body (12).

6. The pick-and-place head (1) according to any one of claims 1 to 3, with at least two gripper units (5), wherein the drive body of the gear transmission devices (3) is constituted as a common drive body (15), which is coupled with a motor (16) for the movement of the common drive body (15).

7. The pick-and-place head (1) according to claim 6, with a housing (4), wherein
- the shafts (6) of the gear transmission devices (3) are disposed on two opposite-facing edge regions of the housing (4),
- the common drive body (15) comprises on opposite-facing wall sections in each case two roll-off faces (14) and is disposed between the shafts (6) in such a way that the shafts (6) rotate upon movement of the common drive body (15).

8. The pick-and-place head (1) according to any one of claims 1 to 7, wherein the shafts (6) of the gear transmission devices (3) are mounted in sliding bearings (7).

## Revendications

1. Tête d'équipement (1) pour équiper des substrats avec des composants (2) électriques, comprenant
au moins un dispositif de transmission (3) et
au moins une unité de grappin (5) pour la retenue des composants (2), qui est couplée avec l'arbre (6), de telle sorte qu'elle tourne en même temps que l'arbre (6), **caractérisée en ce que** le dispositif de transmission (3) présente
- un arbre (6) monté de façon rotative avec une première surface de roulement (11) et
- un corps d'entraînement (12, 15) monté de façon mobile avec une seconde surface de roulement (14),
l'arbre (6) et le corps d'entraînement (12, 15) étant conçus de telle sorte que la première surface de roulement (11) est en interaction avec la seconde surface de roulement (14) sous l'effet d'une force magnétique, de telle sorte que l'arbre (6) tourne lors du déplacement du corps d'entraînement (12, 15) avec le roulement de la première surface de roulement (11) sur la seconde surface de roulement (14).

2. Tête d'équipement (1) selon la revendication 1,
- le corps d'entraînement (12, 15) présentant du matériau ferromagnétique,
- l'arbre (6) présentant un corps de base (8) en forme de barre, qui s'étend dans une direction longitudinale et sur lequel sont disposés deux éléments de roulement (9) ferromagnétiques, espacés dans le sens de la longueur, et un aimant permanent (10) prévu entre les éléments de roulement (9), la première surface de roulement (11) étant conçue sur les surfaces périphériques des éléments de roulement (9).

3. Tête d'équipement (1) selon l'une quelconque des revendications 1 à 2, au moins l'une des premières surfaces de roulement (11) et l'une des secondes surfaces de roulement (14) étant conçues meulées.

4. Tête d'équipement (1) selon l'une quelconque des revendications 1 à 3, chaque dispositif de transmission (3) présentant à chaque fois un corps d'entraînement (12) individuel, et chaque corps d'entraînement (12) individuel étant couplé avec un moteur (13) individuel pour le déplacement du corps d'entraînement (12) individuel.

5. Tête d'équipement (1) selon la revendication 4, chaque corps d'entraînement (12) individuel présentant une forme cylindrique et la seconde surface de roulement (14) étant conçue sur la surface d'enveloppe du corps d'entraînement (12) individuel.

6. Tête d'équipement (1) selon l'une quelconque des revendications 1 à 3, comprenant au moins deux unités de grappin (5), le corps d'entraînement des dispositifs de transmission (3) étant conçu comme corps d'entraînement (15) commun, qui est couplé avec un moteur (16) pour le déplacement du corps d'entraînement (15) commun.

7. Tête d'équipement (1) selon la revendication 6, comprenant un boîtier (4),
- les arbres (6) des dispositifs de transmission (3) étant disposés sur deux zones périphériques se faisant face du boîtier (4),
- le corps d'entraînement (15) commun présentant à chaque fois des secondes surfaces de roulement (14) sur des tronçons de paroi se faisant face et étant disposé entre les arbres (6), de telle sorte que les arbres (6) tournent en cas de déplacement du corps d'entraînement (15) commun.

8. Tête d'équipement (1) selon l'une quelconque des revendications 1 à 7, les arbres (6) des dispositifs de transmission (3) étant montés dans des paliers lisses (7).
